Europäisches Patentamt

European Patent Office

Office européen des brevets

(19)

(11) Numéro de publication. **0 086 133**
**B1**

(12)

# FASCICULE DE BREVET EUROPEEN

(45) Date de publication du fascicule du brevet:
**10.07.85**

(21) Numéro de dépôt: **83400166.1**

(22) Date de dépôt: **25.01.83**

(51) Int. Cl.⁴: **H 03 H 3/00, H 03 H 7/01**

(54) **Procédé de fabrication d'un élément de circuit comportant au moins une inductance et une capacité, élément de circuit ainsi obtenu, et son utilisation dans les circuits de filtrage.**

(30) Priorité: **09.02.82 FR 8202054**

(43) Date de publication de la demande:
**17.08.83 Bulletin 83/33**

(45) Mention de la délivrance du brevet:
**10.07.85 Bulletin 85/28**

(84) Etats contractants désignés:
**DE GB**

(56) Documents cités:
**DE - A - 959 288**
**DE - A - 2 329 417**
**DE - A - 2 329 418**

(73) Titulaire: **L.C.C.-C.I.C.E. - COMPAGNIE EUROPEENNE DE COMPOSANTS ELECTRONIQUES, 50, rue Jean-Pierre Timbaud B.P. 301, F-92402 Courbevoie (FR)**

(72) Inventeur: **Fleuret, Daniel, THOMSON-CSF SCPI 173, bld Haussmann, F-75379 Paris Cedex 08 (FR)**
Inventeur: **Sibille, René, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 173, boulevard Haussmann, F-75379 Paris Cedex 08 (FR)**

BUNDESDRUCKEREI BERLIN

## Description

La présente invention concerne un procédé de fabrication d'un élément de circuit comportant au moins une inductance et une capacité.

Les circuits de ce type sont bien connus dans leur utilisation pour le filtrage. Par exemple, on peut citer les filtres passe haut, passe bas, etc. Depuis quelques années, ce sont développés les alimentations à découpage dans lesquelles l'alimentation en tension continue de valeur régulée est réalisée par découpage d'une tension continue après redressement et filtrage aux bornes d'une capacité. Dans de telles alimentations à découpage, il est généralement nécessaire de disposer d'au moins une self et d'une capacité. Actuellement, ces éléments sont réalisés séparément l'un de l'autre et les inductances disponibles sur le marché sont généralement d'un prix relativement élevé.

Le problème posé ici est de réaliser un composant du type LC simple, bon marché, facile à réaliser de manière industrielle. La demande de brevet allemand DE-A-23 29 418 décrit un composant de type L.C. comportant des films diélectriques et métalliques qui, bobinés simultanément, éventuellement sur un noyau magnétique, permettent de réaliser un composant relativement bon marché. Pour réaliser des inductances importantes, le procédé décrit dans ce brevet nécessite l'utilisation de deux profilés en forme de U qui viennent coiffer le bobinage de manière à refermer le circuit magnétique. Un tel procédé est cependant coûteux car il nécessite, d'une part, la réalisation de pièces supplémentaires et, d'autre part, l'adjonction d'une étape d'assemblage dans le procédé de fabrication de ces composants. Le procédé selon l'invention permet d'éviter ces inconvénients.

Dans ce but le procédé consistant à bobiner sus ur mandrin magnétique simultanément au moins un premier et un deuxième films isolants et au moins un premier et un deuxième films métalliques les films étant disposés de manière à ce que deux films isolants successifs soient séparés sur une partie au moins de leur loguuer par un film métallique tandis que deux films métalliques successifs sont séparés par un film isolant, les contacts électriques étant placés en cours de bobinage aux endroits voulus, de manière à réaliser des parties de composants inductifs dans les enroulements du composant où, avant bobinage, ne se trouve qu'un film métallique, et des parties de composants capacitifs dans les enroulements du composant où, avant bobinage, se trouvent deux films métalliques, est caractérisé en ce que le bobinage ainsi réalisé est enrobé d'une résine isolante comportant un matériau ferro-magnétique dispersé dans celle-ci de manière à fermer le circuit magnétique autour dudit bobinage.

Afin d'améliorer encore le composant ainsi réalisé, le bobinage du composant aura lieu de préférence sur un mandrin en ferrite, la résine isolante contenant un matériau magnétique fermant le circuit magnétique autour de la bobine.

Lorsque les puissances mises en jeu sont suffisamment faibles, on utilisera de préférence des films diélectriques métallisés, l'un des films étant métallisé sur toute sa longueur tandis que l'autre n'est que partiellement métallisé.

Dans certains cas, les connexions sur les films métalliques de la partie capacitive du condensateur pourront être réalisées par schoopage. Dans ce but, les parties de composants correspondant à la partie capacitive de celui-ci comporteront des films métalliques bobinés de telle manière que ceux-ci s'étendent d'un côté au moins jusqu'à l'extrémité du film isolant mais en retrait de l'autre côté. De cette manière, on réalisera un condensateur bobiné comme dans la technique antérieure relative aux condensateurs, tandis que la métallisation se poursuivra pour l'un des films métallisés jusqu'à la fin du bobinage, la largeur du film métallisé étant alors dans cette partie inductive du composant inférieure à la largeur du film isolant, et ce film étant bobiné de manière qu'il ne soit en contact ni d'un côté ni de l'autre avec les choopages.

L'invention concerne également un composant du type LC, comportant un bobinage sur un mandrin magnétique de deux films isolants continus et de deux films métalliques dont l'un est continu et disposé, avant bobinage, entre les deux films isolants et l'autre est discontinu et disposé, avant bobinage, à l'extérieur des deux films isolants, ledit bobinage étant caractérisé ence qu'il est enprobe d'une couche de résine isolante dans laquelle sont dispersées des particules magnétiques, de manière à fermer le circuit magnétique autour en bobinage, en combinaisen avec ledit mandrin magnétique.

De préférence, on disposera au moins deux contacts sur la couche métallique continue et un contact sur chaque couche métallique discontinue. Ce composant comportera également, dans le but d'améliorer son caractère inductif, une partie centrale ou mandrin en matériau magnétique tel qu'un ferrite doux. L'ensemble est enrobé d'une résine isolante, par exemple du type époxy, dans laquelle on mis préalablement en suspension des particules magnétiques dispersées de manière homogène, de manière à former après polymérisation de la résine une couche superficielle qui protège mécaniquement le composant tout en assurant la fermeture du champ magnétique grâce à la présence des particules magnétiques dans cette couche. Le mandrin pourra également être en matériau non magnétique, par exemple en matière plastique moulée, dans lequel se déplacera un batonnet magnétique, tel qu'une vis.

Selon un autre mode de réalisation, et dans le but d'améliorer les performances en haute fréquence de la partie inductive du composant, on pourra introduire à l'intérieur du circuit magnétique en son centre, par exemple selon une section du mandrin magnétique, un aimant permanent permettant de prépolariser la bobine, de manière à imposer en l'absence de courant dans celle-ci, une induction de sens inverse au sens de l'induction produite par le passage du courant dans la bobine, et d'intensité inférieure à l'induction de saturation de cette bobine. Pour plus de détail sur cette technique de prépolarisation, on pourra se reporter par exemple au brevet anglais 747 736, ainsi qu'à l'article de l'»ONDE ELECTRONIQUE«, volume 59 — N° 12 — 1979 — pages 80 et suivantes intitulé »Noyaux en ferrites pour alimentations à découpage« de R. SIBILLE.

Il est à noter que suivant les résultats désirés, les contacts ne seront pas positionnés aux mêmes endroits. Lorsqu'on désire obtenir un composant du type RLC, c'est-à-dire possédant une résistance non négligeable, on éloignera le plus possible l'un de l'autres les contacts de la partie selfique. En revanche, lorsqu'on désire supprimer le plus possible la self parasite relative à la partie capacitive du bobinage, il sera important de placer les deux contacts de la capacité en regard l'un de l'autre.

L'invention sera mieux comprise à l'aide des exemples de réalisation suivants, donnés à titre non limitatif, conjointement avec les figures qui représentent:

la figure 1, une représentation schématique du composant selon l'invention en cours de bobinage,

la figure 2, une vue déployée d'un composant du type LC,

la figure 3, une vue déployée d'un composant comportant deux condensateurs et une self,

la figure 4, une vue déployée d'un composant comportant deux selfs et un condensateur,

la figure 5, une représentation schématique de l'utilisation d'un composant du type LC dans une alimentation à découpage,

la figure 6, une vue à plein d'une variante des films permettant d'obtenir un composant selon l'invention par bobinage et schoopage.

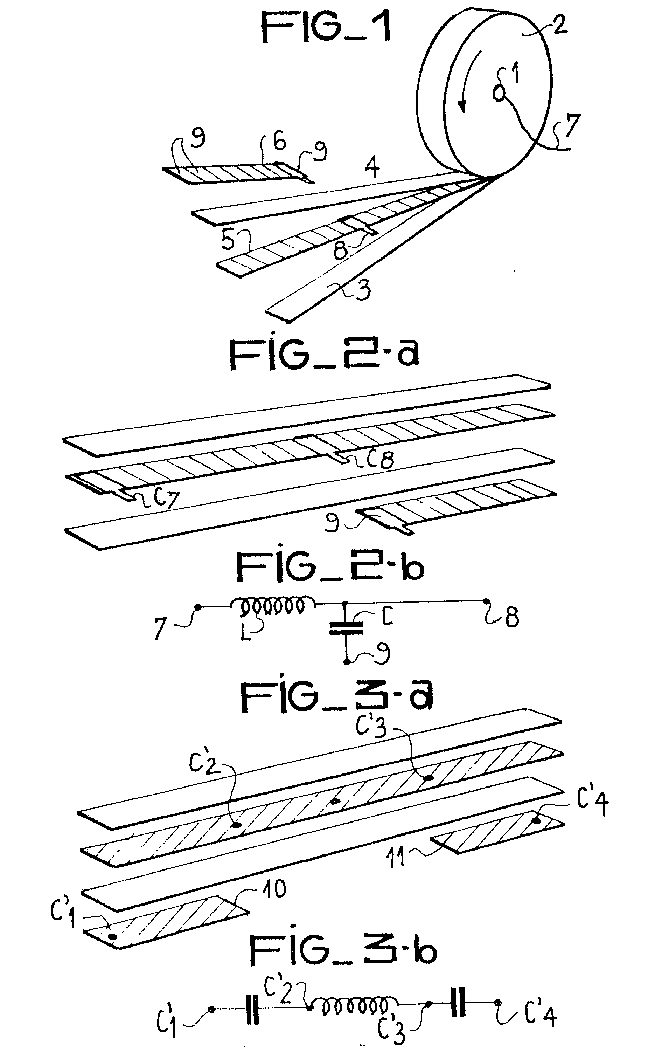

Sur la figure 1, on bobine autour d'un mandrin magnétique 1 dans le sens indiqué par la flèche, un composant selon l'invention 2 comportant successivement de bas en haut un film diélectrique 3, un film métallique 5, un film diélectrique 4, et un film métallique 6. Les films diélectriques 3 et 4 d'une part et métallique 5 d'autre part, sont sensiblement de même longueur. Le film métallique 6 est de longueur plus faible que les films précédents. Dans la partie où les films métalliques 5 et 6 sont en regard l'un de l'autre, séparés par le diélectrique 4, il est aisé de comprendre que l'on réalisera un condensateur, tandis que dans la partie du film métallique 5, situé sur la figure à droite du contact électrique 8, il est aisé de comprendre également que le film métallique 5 n'ayant pas d'autres films étalliques en vis-à-vis, il est aisé de réaliser de cette manière une inductance par bobinage sur le mandrin 1. Dans cet exemple, on prendra un premier contact électrique 7 sur l'extrémité du film 5 au niveau du mandrin 1, un deuxième contact électrique 8 à l'extrémité de la partie du film métallique 5 qui ne comporte pas de films 6 en vis-à-vis, et sur le film métallique 6, par exemple à son extrémité, le contact électrique 9 représentant la sortie d'un condensateur. Dans cet exemple de réalisation, comme dans trans les exemples suivant, le composant selon l'invention est enrobé d'une résine isolante comportant un matériel ferro-magnétique dispersé danscelle-si, de manière à fermer le circuit magnétique autour du bobinage.

Sur la figure 2, on a représenté une vue schématique déployée du composant d la figure 1 déroulé à plat. Sur cette figure, les mêmes éléments que ceux de la figure précédente portent les mêmes références. Ainsi qu'on peut le constater, sur la figure 2a, on reconnaît la superposition des films tels que décrits sur la figure 1, tandis que sur la figure 2b il est aisé de constater qu'entre les extrémités 7 et 8, on a réalisé une inductance tandis qu'entre les extrémités 8 et 9 on a réalisé un condensateur.

On notera qu'en disposant les connexions 8 et 9 en regard, on a constitué une ligne de part et d'autre du diélectrique, ce qui limite l'inductance parasite de l'élément capacitif.

Sur la figure 3, est représentée une autre variante de réalisation du composant selon l'invention. Sur cette figure, les mêmes éléments que ceux des figures précédentes portent les mêmes références. Comme précédemment, on superpose deux films diélectriques entre lesquels est interposé un film métallique, ces films étant continus de même longueur, tandis que sur le bas de la figure sont disposées deux parties 10 et 11 de films métalliques discontinus. De cette manière, le schéma équivalent du circuit réalisé entre les différents points de connexion $C'_1$, $C'_2$, $C'_3$ et $C'4$ est représenté à la figure 3b.

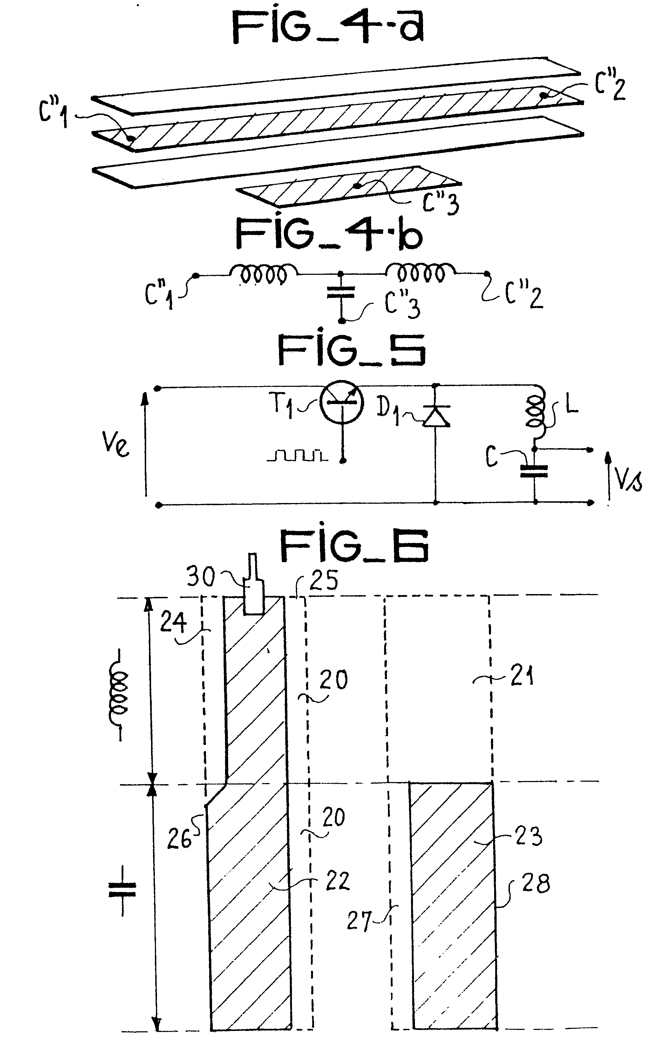

Sur la figure 4, est réalisée une autre variante du composant selon l'invention. Comme précédemment, les films 3, 4 et 5 sont continus et sensiblement de même longueur tandis que le film 6 est de longueur plus réduite et disposé entre les extrémités des films précédents. De cette manière, il est aisé de comprendre que l'on réalise ainsi un circuit tel que représenté sur la figure 4b avec deux selfs en série et un condensateur en parallèle.

Sur la figure 5, est représenté schématiquement un circuit de découpage d'une alimentation de ce type. Une tension continue VE d'entrée est découpée par le transistor $T_1$ sur la base duquelle on envoie un signale de commande haute fréquence de l'ordre de 100 KHz, permettant de le rendre alternativement conducteur et bloqué. Le signal en sortie du transistor sur l'émetteur de celui-ci est envoyé dans un circuit comportant une diode $D_1$ montée in inverse et une self L connectée en série avec un condensateur et en parallèle sur cette diode. La tension de sortie VS est récupérée aux bornes du condensateur C. Le circuit LC utilisé dans cette alimentation à découpage peut être avantageusement un circuit tel que représenté, avant bobinage, sur les figures 1 ou 2.

Sur la figure 6, on a représenté une variante de films diélectriques métallisés permettant de réaliser un composant selon l'invention dans lequel les connexions aux bornes du condensateur sont réalisées par schoopage. Les films diélectriques 20 et 21 sont de largeur supérieure aux films métalliques 22 et 23. Le film métallique 22 est séparé en deux parties d'inégales largeurs. La partie disposée en haut sur la figure de largeur inférieure à la largeur du film 20 est disposée de manière à laisser deux lisières non métallisées 24 et 25 correspond à la zone selfique du composant, tandis que la zone située en bas sur la figure du film 22 de largeur inférieure à la largeur du film 20 mais ne comportant qu'une seule lisière non métallisée 20 correspond à la zone capacitive du composant, puisque sur son autre lisière 26, le film diélectrique et le film métallique se recouvrent complètement. Le film diélectrique 21 comporte une partie supérieure non métallisée (zone selfique) et une partie inférieure métallisée 23 comportant une seule lisière non métallisée 27, l'autre lisière 28 correspondant à la superposition des films métalliques et diélectriques. Pour réaliser le composant selon l'invention, on superpose (par glissement latéral) sur la figure 6 les deux films montrés sur cette figure le mandrin étant disposé à la partie basse des deux films sur la figure et l'on bobine simultanément ces deux films sur ce mandrin. Lorsque le bobinage est terminé, on fixe de manière connue en soi les deux films par exemple à l'aide d'une bande adhésive puis l'on réalise un schoopage sur les faces latérales du composant ainsi bobiné. Ce schoopage, qui consiste à projeter du métal en fusion sur les faces latérales du composant permet de relier entre elles tautes les spires de la lisière 26 d'une part et toutes les spires de la lisière 28 d'autre part et disposer sur ces schoopages des connexions électriques qui seront les connexions de la partie capacitive du composant. A l'extrémité de la bande métallique 22, sur la partie haute de la figure, sera disposé un contact électrique 30, avant schoopage de l'ensemble, ce contact permettant de connecter électriquement l'autre extrémité de la self, la première extrémité de celle-ci étant la même que la connexion de schoopage se trouvant sur la lisière 26.

## Revendications

1. Procédé de fabrication d'un élément de circuit comportant au moins une inductance et une capacité, consistant a bobiner sur un mandrin magnetique (1) simultanement au moins un premier (3) et un deuxième (4) films isolants et au moins un premier (5) et un deuxième (6) films métalliques, les films étant disposés de manière à ce que deux films isolants successifs (3, 4) soient séparés sur une partie au moins de leur longueur par un film métallique et deux films métalliques successifs (5, 6) par un film isolant, des contacts électriques (7, 8, 9) étant placés en cours de bobinage ou après bobinage aux endroits voulus, de manière à réaliser des parties de composants inductifs dans les enroulements du composant où, avant bobinage, ne se trouve qu'un film métallique et des parties de composants capacitifs dans les enroulements du composant où, avant bobinage, se trouvent deux films métalliques, caractérisé en ce que le bobinage ainsi réalisé est enrobé d'une résine isolante comportant un matériau ferro-magnétique dispersé dans celle-ci de manière à fermer le circuit magnétique autour dudit bobinage.

2. Procédé selon la revendication 1, caractérisé en ce que le composant est bobiné sur un mandrin (1) en ferrite doux.

3. Procédé selon l'une des revendications 1 à 2, caractérisé en ce que le composant est réalisé à partir de films diélectriques métallisés, l'un des films étant métallisé sur toute sa longueur, l'autre n'étant que partiellement métallisé.

4. Procédé selon la revendication 3, caractérisé en ce que la partie métallisée du film métallisé sur toute sa longueur comporte une première partie dans laquelle le film métallique est entouré par deux lisières isolantes (20, 24) et une deuxième partie dans laquelle le film métallique n'est entouré que par une seule lisière isolante (20), l'autre film qui n'est que partiellement métallisé comportant une lisière isolante (27) sur son film métallisé situé à l'opposé de la lisière isolante du premier film.

5. Procédé selon l'une des revendications 1 à 4, caractérisé en ce que des contacts électriques de l'élément de circuit sont réalisés par schoopage après bobinage de celui-ci mais avant enrobage avec la résine.

6. Composant du type LC, comportant un bobinage sur un mandrin magnétique de deux films isolants continus (3, 4) et de deux films métalliques dont l'un est continu (5) et disposé, avant bobinage, entre les deux films isolants et l'autre est discontinu (6) et disposé, avant bobinage, à l'extérieur des deux films isolants, caractérisé en ce atte ledit bobinage est enrobé d'une couche de résine isolante dans laquelle sont dispersées des particules magnétiques de manière à fermer le circuit magnétique auteour du bobinage, en combinaison avec ledit mander in magnétique.

7. Composant selon la revendication 6, caractérisé en ce qu'un contact électrique (7, 8) est disposé à chaque extrémité du film continue et un contact électrique (9) est disposé sur chaque film métallique discontinue.

8. Composant selon l'une des revendications 6 ou 7, caractérisé en ce que le mandrin (1) disposé au centre du bobinage, selon son axe, est muni d'un filetage dans lequel vient se déplacer un matériau magnétique.

9. Composant selon l'une des revendications 6 à 8, caractérisé en ce qu'un aimant permanent est disposé dans le circuit magnétique de manière à prépolariser la self du composant.

10. Composant selon l'une des revendications 6 à 9, caractérisé en ce qu'il est constitué par deux films métallisés bobinés l'un sur l'autre, comportant deux contacts électriques réalisés par schoopage des flancs latéraux (26, 28) dudit composant.

11. Utilisation du composant selon l'une ces revendications 6 à 10 dans les circuits de filtrage.

**Patentansprüche**

1. Verfahren zur Herstellung eines Schaltungselements mit mindestens einer Induktivität und einer Kapazität, wobei auf einen Magnetkern (1) gleichzeitig mindestens eine erste (3) und eine zweite Isolierfolie (4) und mindestens eine erste (5) und eine zweite Metallfolie (6) so aufgewikkelt werden, daß zwischen zwei aufeinanderfolgenden Folien (3, 4) über mindestens einen Teil ihrer Länge eine Metallfolie und zwischen zwei aufeinanderfolgenden Metallfolien (5, 6) eine Isolierfolie liegt, und wobei während oder nach dem Wickeln an den gewünschten Stellen elektrische Kontakte (7, 8, 9) so angebracht werden, daß Bereiche von induktiven Komponenten in den Wicklungen des Bauteils entstehen, wo vor dem Wickeln nur eine Metallfolie vorhanden ist, und Bereiche von kapazitiven Komponenten in den Wicklungen des Bauteils entstehen, wo vor dem Wickeln zwei Metallfolien vorhanden sind, dadurch gekennzeichnet, daß die so erhaltene Wicklung mit einem Isolierharz umgeben wird, das ein ferromagnetisches Material in Dispersion enthält, so daß der Magnetkreis um die Wicklung herum geschlossen ist.

2. Verfahren nach Anspruch 1, dadurch gekennzeichnet, daß das Bauteil auf einen Weicheisenkern (1) gewickelt ist.

3. Verfahren nach einem der Ansprüche 1 bis 2, dadurch gekennzeichnet, daß das Bauteil ausgehend von metallisierten dielektrischen Folien gebildet wird, von denen die eine über ihre ganze Länge und die andere nur teilweise metallisiert ist.

4. Verfahren nach Anspruch 3, dadurch gekennzeichnet, daß der metallisierte Bereich der über die ganze Länge metallisierten Folie einen ersten Bereich, in dem die Metallfolie von zwei isolierenden Rändern (20, 24) umgeben ist, und einen zweiten Bereich enthält, in dem die Metallfolie nur von einem einzigen Isolierrand (20) umgeben ist, während die andere Folie, die nur teilweise metallisiert ist, einen isolierenden Rand (27) auf ihrer metallisierten Folie enthält, die dem isolierenden Rand der ersten Folie entgegengesetzt angeordnet ist.

5. Verfahren nach einem der Ansprüche 1 bis 4, dadurch gekennzeichnet, daß elektrische Kontakte des Schaltungselements durch Metallisierung des Spulenwickelrands nach dem Aufwikkeln, aber vor der Umhüllung mit dem Harz hergestellt werden.

6. Bauteil vom LC-Typ mit einer Wicklung zweier kontinuierlicher isolierender Folien (3, 4) und zweier metallischer Folien, von denen eine (5) kontinuierlich ist und vor dem Wickeln zwischen zwei Isolierfolien eingelegt ist, während die andere diskontinuierlich (6) ist und vor dem Wickeln außerhalb der beiden isolierenden Folien angeordnet ist, und mit einem magnetischen Kern (1), dadurch gekennzeichnet, daß der Wickel von einer Schicht eines isolierenden Harzes umgeben ist, in der magnetische Partikel in Dispersion vorhanden sind, so daß der Magnetkreis um den Wickel herum in Kombination mit dem Magnetkern geschlossen wird.

7. Bauteil nach Anspruch 6, dadurch gekennzeichnet, daß ein elektrischer Kontakt (7, 8) an jedem Ende der kontinuierlichen Folie und ein elektrischer Kontakt an jeder diskontinuierlichen metallischen Folie angebracht ist.

8. Bauteil nach einem der Ansprüche 6 oder 7, dadurch gekennzeichnet, daß der Kern (1), der im Zentrum des Wickels in Achsrichtung angeordnet ist, ein Gewinde aufweist, in dem ein magnetisches Material verschiebbar angeordnet ist.

9. Bauteil nach einem der Ansprüche 6 bis 8, dadurch gekennzeichnet, daß ein Auermagnet im Magnetkreis so angeordnet ist, daß er die Induktivität des Bauteils vorpolarisiert.

10. Bauteil nach einem der Ansprüche 6 bis 9, dadurch gekennzeichnet, daß es aus zwei metallisierten Folien besteht, die aufeinandergewikkelt sind, mit zwei elektrischen Kontakten, die durch Metallisierung der Seitenflanken (26, 28) des Bauteils erzielt sind.

11. Verwendung des Bauteils nach einem der Ansprüche 6 bis 10 in Filterschaltkreisen.

**Claims**

1. A method for manufacturing a circuit element comprising at least one inductance and one capacitor, this method consisting of enrolling on a magnetic core (1) simultaneously at least a first (3) and a second insulating film (4) and at least a first (5) and a second metallic film (6), these films being disposed in such a manner that two successive insulating films (3, 4) are separated on at least a part of their length by a metallic film and that two successive metallic films (5, 6) are separated by an insulating film, electrical contacts (7, 8, 9) being placed during the establishment of the coil or thereafter at the desired locations in such a way that zones of inductive components are realized in the windings of the component at locations where prior to the establishment of the coil there is only a metallic film, and that zones of condensor components are realized in the windings of the component at locations, where prior to the establishment of the coil, two metallic films are present, characterized in that the coil thus obtained is coated by an insulating resin comprising a ferromagnetic material which is dispersed in the resin in such a way that the magnetic circuit is closed around said coil.

2. A method according to claim 1, characterized in that the component is wound on a core (1) made of soft iron.

3. A method according to one of the claims 1 to 2, characterized in that the component is made from metal-coated dielectric films, one of these films being metal-coated over its entire length, while the other is metal-coated only partially.

4. A method according to claim 3, characterized in that the metal-coated zone of the film which is metal-coated over its entire length comprises a first zone in which the metallic film is surrounded by two insulating rims (20, 24), and a second zone, in which the metallic film is only surrounded by one insulating rim (20), whereas the other film, which is only partially metal-coated comprises an insulating rim (27) on its metal-coated film situated at the opposite side of the insulating rim of the first film.

5. A method according to one of claims 1 to 4, characterized in that the electrical contacts of the circuit elements are realized by metal-coating of the front sides of the coil prior to the envelopping of the coil with the resin.

6. A component of LC-type comprising a coil on a magnetic core (1) of two continuous insulating films (3, 4) and two metallic films, one of which is continuous (5) and disposed prior to the coil establishment between the two insulating films, whereas the other (6) is discontinuous and is disposed prior to the establishment of the coil outside of the two insulating films, characterized in that said coil is coated by a layer of an insulating resin in which magnetic particles are dispersed in such a manner that the magnetic circuit around the coil is closed in combination with said magnetic core.

7. A component according to claim 6, characterized in that an electrical contact (7, 8) is disposed at each end of the continuous film, and an electrical contact (9) is disposed on each discontinuous metallic film.

8. A component according to one of the claims 6 or 7, characterized in that the core (1) disposed along the axis in the center of the coil is equipped with a thread in which a magnatic material can be displaced.

9. A component according to one of claims 6 to 8, characterized in that a permanent magnet is disposed in the magnetic circuit in order to bias the inductance of the component.

10. A component according to one of the claims 6 to 9, characterized in that it is constituted by two metall-coated films which are wound one on the other and comprise two electrical contacts realized by metal-coating of the lateral flancs (26, 28) of said component.

11. The use of the component according to one of claims 6 to 10 in filter circuits.

FIG_1

FIG_2·a

FIG_2·b

FIG_3·a

FIG_3·b

# FIG_4·a

$C''_1$     $C''_2$

# FIG_4·b

$C''_3$

# FIG_5

$C''_1$    $C''_3$    $C''_2$

# FIG_6

$V_e$    $T_1$   $D_1$   $L$   $C$   $V_s$

30   25   24   20   21   26   20   23   22   28   27